Europäisches Patentamt

European Patent Office

Office européen des brevets

(11) Publication number: **0 083 664**
**B1**

# EUROPEAN PATENT SPECIFICATION

(45) Date of publication of patent specification: 23.04.86

(51) Int. Cl.⁴: **H 03 C 1/36**

(21) Application number: 82902204.5

(22) Date of filing: 20.07.82

(86) International application number:
PCT/JP82/00280

(87) International publication number:
WO 83/00411 03.02.83 Gazette 83/04

(54) AMPLITUDE MODULATION CIRCUIT.

(30) Priority: 20.07.81 JP 113848/81

(43) Date of publication of application:
20.07.83 Bulletin 83/29

(45) Publication of the grant of the patent:
23.04.86 Bulletin 86/17

(84) Designated Contracting States:
DE FR GB

(56) References cited:
JP-A-54 079 547
JP-A-56 120 203

WIRELESS WORLD, vol. 68, no. 12, December
1962, LONDON (GB) R.C. FOSS et al.: "LC
oscillator design", pages 595-597

PATENTS ABSTRACTS OF JAPAN, Section E,
vol. 3, no. 102, August 29, 1979

IBM TECHNICAL DISCLOSURE BULLETIN, vol.
17, no. 3, August 1974, NEW YORK (US) D.M.
TRAUB: "Amplitude modulator", pages 941-942

(73) Proprietor: SANYO ELECTRIC CO., LTD.
18, 2 chome, Keihan-Hondori
Moriguchi-shi Osaka 570 (JP)

(72) Inventor: MURAKAMI, Yoshihiro
1-3-11, Hiranoya, Daito-shi
Osaka 574 (JP)
Inventor: HOSOYA, Nobukazu
580-7, Hidehara Heguri-cho
Ikoma-gun, Nara 636 (JP)

(74) Representative: Glawe, Delfs, Moll & Partner
Patentanwälte
Rothenbaumchaussee 58 Postfach 2570
D-2000 Hamburg 13 (DE)

## Description

### Field of technology

This invention relates to an amplitude modulation circuit "hereinafter referred to as "AM circuit") and, particularly, to an AM circuit having a constant modulation degree.

Such an AM circuit having a constant modulation degree is built in an RF modulator for, when a multiplex sound signal reproduced by the use of, for example, a video tape recorder (VTR) is supplied to an antenna terminal of a television receiver set, high frequency modulating and supplying a VTR output and is used to form a modulation wave to be modulated (amplitude-modulated wave) using as a modulating signal a pilot signal of predetermined frequency necessary to discriminate the type of the multiplex sound signal.

### Background art

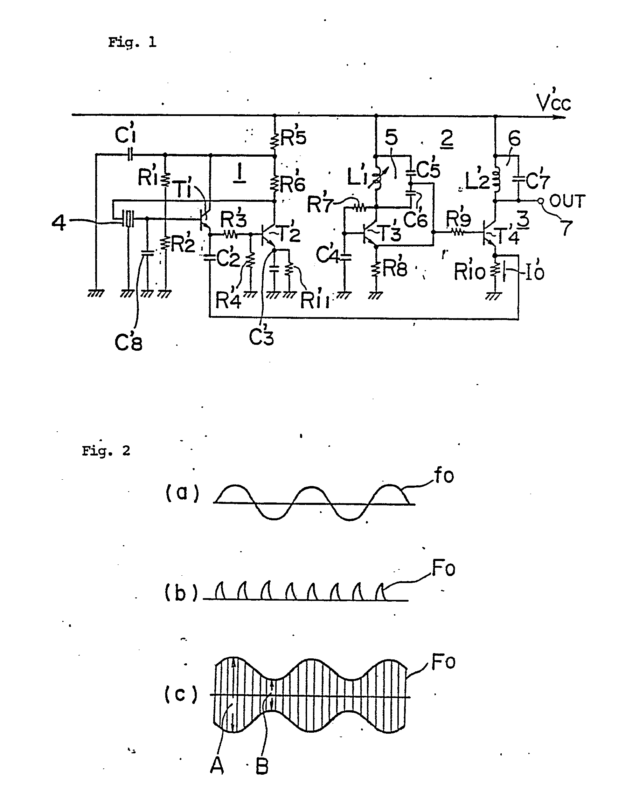

This type of prior art AM circuit including its peripheral circuits is shown in Fig. 1. The illustrated circuit is constituted by a modulating signal oscillating circuit (1), a carrierwave oscillating circuit (2) and a modulation circuit (3).

The modulating signal oscillating circuit (1) is comprised of resistors $(R_1')\sim(R_6')$ and $(R_{11}')$, transistors $(T_1')$ and $(T_2')$ capacitors $(C_1')$, $(C_2')$, $(C_3')$ and $(C_8')$ and a reed-filter (4) with its oscillating loop being the base of the transistor $(T_2')\rightarrow$ its collector$\rightarrow$ the reed filter (4)$\rightarrow$ the base of the transistor $(T_1')\rightarrow$ its emitter$\rightarrow$ the resistor $(R_3')\rightarrow$ the base of the transistor $(T_2')$ and starts it oscillation when the gain of this loop is 1 or more. The oscillating frequency is determined depending on the frequency selectivity of the reed filter (4) (for example, 922.5 Hz), and the waveform of the modulated signal is a sine wave $f_0$ as shown in Fig. 2(a).

The carrierwave oscillating circuit (2) is comprised of a transistor $(T_3')$, resistors $(R_7')$ and $(R_8')$, capacitors $(C_4')$, $(C_5')$ and $(C_6')$ and an inductance coil $(L_1')$ with its oscillating loop being the emitter of the transistor $(T_3')\rightarrow$ the capacitor $(C_6')\rightarrow$ the collector of the transistor $(T_3')\rightarrow$ its emitter and starts its oscillation when the gain of this loop is 1 or more. The oscillating frequency is determined by a constant of a resonance circuit (5) constituted by the capacitor $(C_6')$ and the inductance coil $(L_1')$ and is expressed as follows provided that the carrierwave oscillating frequency is expressed as $F_0$:

$$F_0 = \frac{1}{2\pi\sqrt{L_1'C_6'}}\text{[Hz]} \qquad (1)$$

The oscillating waveform is such as shown in Fig. 2(b) because the transistor $(T_3')$ undergoes a switching operation according to the charging and discharging of the resistor $(R_8')$ and the capacitor $(C_5')$. However, in this construction, it often occurs that a high harmonic and a side-band wave tend to adversely affect the illustrated circuit and other circuit not shown, for example, a sound processing circuit, through a common grounded line and a power supply line.

The modulation circuit (3) is comprised of resistors $(R_9')$ and $(R_{10}')$, a transistor $(T_4')$, an inductance coil $(L_2')$ and a capacitor $(C_7')$, and the carrierwave supplied from the carrierwave oscillating circuit (2) to the transistor $(T_4')$ through the resistor $(R_9')$ is shaped by a resonance circuit (6) which acts as a filter circuit composed of $(L_2')$ and $(C_7')$ with its high harmonic and side-band consequently suppressed. The emitter potential of the transistor $(T_4')$ is varied by a modulating signal supplied to the emitter of the transistor $(T_4')$ from the modulating signal oscillating circuit (1) through the capacitor $(C_2')$, and the current flowing through the transistor $(T_4')$ changes. The gain of the modulating circuit (3) is determined by the product of the resonance impedance of the resonance circuit (6), formed by the inductance coil $(L_2')$ and the capacitor $(C_7')$, times the current flowing through the transistor $(T_4')$. Therefore, when the current flowing through the transistor $(T_4')$ varies in response to the modulating signal, the amplitude of the carrierwave varies and the waveform of an output at an output terminal (7) is amplitude-modulated as shown in Fig. 2(c). The AM degree m is expressed by the following equation using wave peak values A and B as shown in Fig. 2(c):

$$m = \frac{A-B}{A+B}\times100(\%) \qquad (2)$$

However, with the modulation circuit (3) of the above described type, the AM degree tends to change with the amplitude level of the modulating signal. In other words, variation in oscillating level of the modulating signal oscillating circuit (1) results in variation in AM degree. Such being the case, the AM circuit is not suited to achieve a fixed modulation degree. Though the use of a modulating signal oscillating circuit (1) of high precision can be contemplated, not only is it difficult to eliminate any variation of the oscillating level for any condition, but also it results in the increased cost.

In addition, the modulation circuit (3) must be provided with the resonance circuit (6) comprising the coil $(L_2')$ and the capacitor $(C_7')$ and therefore, the circuit shown in fig. 1 is not suited for the incorporation into an integrated circuit (hereinafter referred to as "IC"). Although it can be contemplated to connect a circuit including the inductance coil and the read filter exteriorly to the IC while the remaining circuits are fabricated into the IC, this method would result in an increased number of terminal pins.

From the document Wireless World, Vol. 68, No. 12, 1962, p. 595—597, there has been known an amplitude modulation circuit of the type defined in the precharacterizing part of claim 1 wherein a transistor controlling the oscillator current is connected to form a feedback pair with another transistor which receives the modulation signal at its gate. This results in continuous modulation of the oscillator current in proportion to the modulation signal, and accordingly a variation of the amplitude of the modulation signal will result in variation of the oscillator current and hence in variation of the modulation degree of the modulated carrier-wave. Moreover, this prior art circuit employs inductive coupling between a coil of the resonating circuit and a coil connected between the gates of the two transistors forming the differential amplifier of the transistors, and the necessity of having inductance coupled coils makes this circuit not suited for implementation as an integrated circuit.

It is an object of the invention to provide an amplitude modulation of the aforementioned type suitable for implementation as an integrated circuit, which can provide a stable constant modulation degree irrespective of changes of the strength or level of the modulating signal.

The amplitude modulation circuit according to the invention, as defined in claim 1, solves this object by providing only two alternative levels of predetermined current supplied to said oscillator, and by switching between these levels of current responsive of the modulating signal. Changes of strength of the modulating signal will not affect either of the two levels of current, and hence the modulation degree will not change.

The ratio between said two predetermined constant current values, and hence the modulation degree, can be easily determined by selecting the ratio of the emitter surface areas and/or by selecting the ratio of numbers, of pluralities of transistors connected to be alternatingly switched responsive to said modulating signal and providing alternate paths of current, as described in the subclaims.

The complete circuit, with the exception of the resonating circuit, does not include an inductance coil and can be implemented in an IC, to which a resonating circuit having an inductance coil· can be connected as an outside component occupying one terminal only of the IC.

Preferred embodiments of the invention will be described with reference to the drawings.

Fig. 1 is a circuit diagram showing the prior art AM circuit including the peripheral circuits.

Fig. 2 is a diagram used to explain various waveforms in portions of the circuit shown in Fig. 1.

Fig. 3 is a circuit diagram showing an AM circuit according to this invention.

Fig. 4 is a diagram used to explain the operation of each portion of the circuit shown in Fig. 3.

Fig. 5 is a graph showing the frequency characteristic of a wavecarrier oscillating circuit of this invention.

Fig. 6 is a circuit diagram showing another construction of a constant current adjusting means.

Fig. 7 is a schematic plan view of one transistor constructed in the form of an IC.

Fig. 8 is a block diagram showing a portion of a device for the changeover of a multiplex sound signal using the AM circuit to which this invention is applied.

Best mode for carrying out the invention

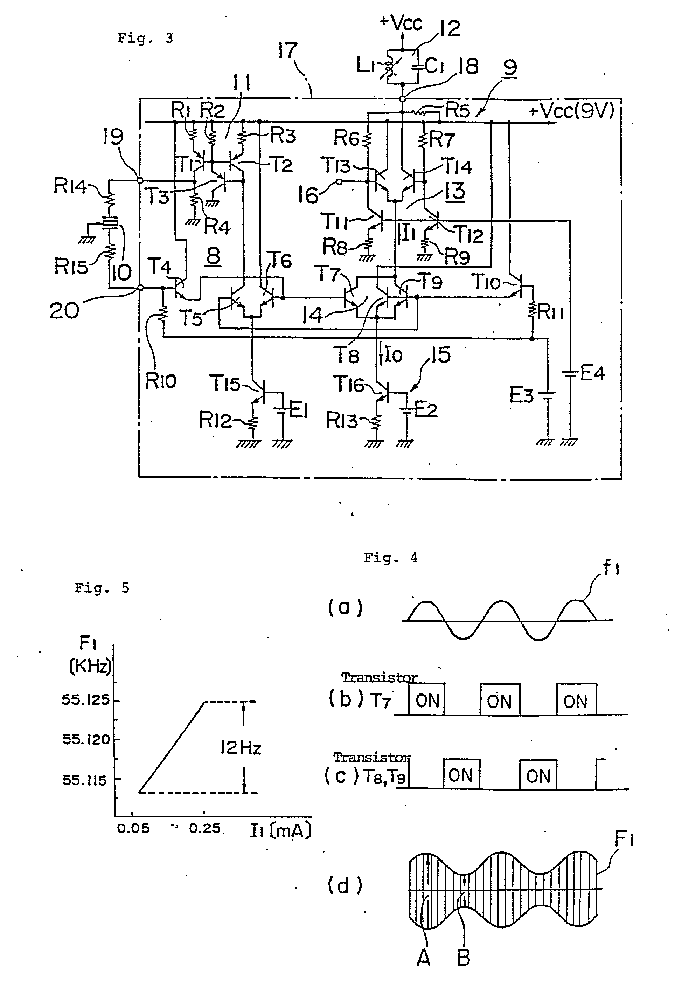

An embodiment of this invention is shown in Fig. 3. A circuit shown includes a modulating signal oscillating circuit (8), and a carrierwave oscillating circuit (9) which concurrently serves as a modulation circuit.

The modulating wave oscillating circuit (8) comprises transistors $(T_1)\sim(T_6)$ and $(T_{15})$, resistors $(R_1)\sim(R_4)$, $(R_{10})$, $(R_{12})$, $(R_{14})$ and $(R_{15})$ and a reed filter (10). And, the oscillating loop thereof is the base of the transistor $(T_6)\rightarrow$ the emitter thereof$\rightarrow$ the emitter of the transistor $(T_5)\rightarrow$ from the collector thereof to the collector of a transistor $(T_1)$ through a current mirror circuit (11) formed by the transistors $(T_1)$, $(T_2)$ and $(T_3)$ and the resistors $(R_1)$, $(R_2)$, $(R_3)$ and $(R_4)\rightarrow$ the resistor $(R_{14})\rightarrow$ the reed filter (10)$\rightarrow$ the resistor $(R_{10})\rightarrow$ the resistor $(R_{15})\rightarrow$ the base of the transistor $(T_4)\rightarrow$ the emitter thereof$\rightarrow$ the base of the transistor $(T_6)$. When the gain of this system is one or more, oscillation takes place, the oscillating frequency is determined by the frequency selectivity of the reed filter (10). The reed filter (10) is identical with that shown in Fig. 1, having a high Q and resonates at a frequency of 922.5 Hz$\pm$0.1 Hz.

The carrierwave oscillating circuit (9) concurrently serving as the modulating circuit comprises transistors $(T_7)\sim(T_{14})$ and $(T_{16})$, a variable inductance coil $(L_1)$, a capacitor $(C_1)$·and resistors $(R_5)\sim(R_9)$ and $(R_{13})$.

The details of connection are as follows. The carrierwave oscillating circuit (9) includes a differential amplifier (13), and two NPN-type transistors $(T_{13})$ and $(T_{14})$ forming a differential pair of the differential amplifier (13) have their emitters connected together and includes a constant current source (15) connected to the emitters, that is, a ground terminal thereof. This constant current source (15) has the transistor $(T_{16})$ having its base connected with a constant voltage source $(E_2)$ and its emitter grounded through the resistor $(R_{13})$.

One transistor $(T_{14})$ forming a part of the differential pair of the differential amplifier (13) has its collector connected to one terminal of a resonance circuit (12) comprised of a parallel connection of the variable inductance coil $(L_1)$ and the capacitor $(C_1)$. The other terminal of the resonance circuit (12) is connected to a common power source +Vcc (for example, 9V). This resonance circuit forms a circuit for determining the oscillating frequency of the carrierwave.

An output terminal of the resonance circuit (12) is connected through the resistor $(R_6)$ to the base of the other transistor $(T_{13})$ forming another part of the differential pair. To this base is connected the collector of the transistor $(T_{11})$ having its emitter grounded through the resistor $(R_8)$. The resistors $(R_6)$ and $(R_8)$ form a level shift circuit for reducing the feedback amount of the differential amplifier (13).

The transistor ($T_{13}$) has its collector connected to the common power source +Vcc. On the other hand, the transistor ($T_{14}$) has its collector connected through the resistor ($R_5$) to the common power source +Vcc and its base connected through the resistor ($R_7$) to the common power source +Vcc. To this base is connected the collector of the transistor ($T_{12}$) having its emitter grounded through the resistor ($R_9$). The respective bases of the transistors ($T_{11}$) and ($T_{12}$) are connected in common to a constant voltage source ($E_4$). The transistors ($T_{11}$) and ($T_{12}$) to which a constant voltage is supplied from this bias power source ($E_4$) serve to prevent an alternate current component (AC component) from being grounded. This is for the purpose of avoiding any undesirable influence the AC component having a high energy may bring about on the other circuits through a common grounded portion of the circuit.

A constant current adjusting means (14) comprised of a plurality of NPN-type transistors is connected between the differential amplifier (13) and the current source (15). This constant current adjusting means (14) comprises transistors ($T_7$), ($T_8$) and ($T_9$) having their emitters connected together and also to the collector of the transistor ($T_{16}$). The transistors ($T_7$) and ($T_9$) have their collectors connected also together and also to the common emitter of the transistors ($T_{13}$) and ($T_{14}$) forming the differential pair. On the other hand, the transistor ($T_8$) has its collector connected to the common power source +Vcc. The bases of the transistors ($T_8$) and ($T_9$) are connected together and in turn to the emitter of the transistor ($T_{10}$). The collector of the transistor ($T_{10}$) is connected to the common power source +Vcc and the base thereof is connected through the resistor ($R_{11}$) to a constant voltage source ($E_3$). On the other hand, the transistor ($T_7$) has its base connected to the base of the transistor ($T_6$) forming the modulating signal oscillating circuit (8). The base of the transistor ($T_5$) forming the differential pair together with the transistor ($T_6$) is connected to the bases of the transistors ($T_9$) and ($T_8$) so as to apply a constant bias to these bases of the transistors ($T_9$) and ($T_8$). This constant current adjusting means (14) serves to vary the constant current ($I_1$) which is selectively fed to the differential pair ($T_{13}$), ($T_{14}$) in dependence on the switching of the transistors ($T_7$), ($T_8$) and ($T_9$).

A modulating signal synthesized by the modulating signal oscillating circuit (8) emerges from the base of the transistor ($T_6$) and is supplied to the base of the transistor ($T_7$) of the constant current adjusting means (14). A wave so modulated is outputted from a terminal (16). In the carrierwave oscillating circuit (9), the oscillating loop is the base of the transistor ($T_{13}$)→ the emitter thereof→ the emitter of the transistor ($T_{14}$)→ the collector thereof→ the resistor ($R_6$)→ the base of the transistor ($T_{13}$), and when the gain of this system is 1 or more, oscillation takes place. The oscillating frequency is determined by the constant of the resonance circuit (12) formed by the coil ($L_1$) and the capacitor ($C_1$) and is expressed as follows:

$$F_1 = \frac{1}{2\pi\sqrt{L_1 C_1}} \qquad (3)$$

wherein $F_1$ is the oscillating frequency of the carrierwave. The oscillating power (the oscillating amplitude of the carrierwave) is determined by the product of the current I, flowing through the differential pair ($T_{13}$), ($T_{14}$) forming the differential amplifier (13) times the resonance impedance of the resonance circuit (12).

Any change in oscillating frequency $F_1$ as a result of change in current $I_1$ flowing through the differential pair ($T_{13}$) ($T_{14}$) is almost of a negligible value as shown in Fig. 5.

Referring to Figs. 3 and 4, when a modulating signal $f_1$ of a level sufficient to cause the differential pair ($T_7$), ($T_8$), ($T_9$) to undergo a switching action is supplied to the base of one of the transistors ($T_7$), ($T_8$) and ($T_9$) forming the differential pair of the constant current adjusting means (14), that is, the base of the transistor ($T_9$) (See Fig. 4(a)), the transistor ($T_7$) is switched on in response to the sine wave of half cycle above the constant bias of the modulating signal $f_1$, while the transistors ($T_8$) and ($T_9$) are switched off. The current $I_1$ flowing through the differential pair ($T_{13}$), ($T_{14}$) of the carrierwave oscillating circuit (9) is equal to the current $I_0$ supplied from the constant current source (15) (which is the total current flowing through the transistors ($T_7$), ($T_8$) and ($T_9$). Conversely, when in response to the sine wave of half cycle below the modulating signal $f_1$ the transistor ($T_7$) is switched off while the transistors ($T_8$) and ($T_9$) are switched on, the constant current $I_0$ is divided by the transistors ($T_8$) and ($T_9$), and the current $I_1$ flowing through the differential pair ($T_{13}$), ($T_{14}$) is equal to half the current $I_0$. As stated above, the carrierwave oscillating level is determined by the product of the resonance impedance of the resonance circuit (12) times the current $I_1$ flowing through the differential pair ($T_{13}$), ($T_{14}$) and, therefore, the carrierwave $F_1$ is amplitude-modulated by the modulating signal ($f_1$), as shown in Fig. 4(a), as can be seen from Fig. 4(d). At this time, since the AM degree is given by the equation (2), the modulation degree m can be expressed as follows:

$$\frac{k(I_0 - \dfrac{I_0}{2})}{k(I_0 + \dfrac{I_0}{2})} \times 100 = \frac{\dfrac{1}{2}}{\dfrac{3}{2}} \times 100 = 33.3(\%)$$

It is to be noted that k represents a proportional constant. Needless to say, this applies where the transistors ($T_7$), ($T_8$) and ($T_9$) have equal characteristics.

Thus, since the constant current of the differential pair can be adjusted by causing the transistors, which are inserted in the circuit for the flow of the constant current and operable differentially, to undergo the switching action in response to the modulating signal, the modulation degree can be maintained at a constant value irrespective of any change occurring in the amplitude level of the modulating signal.

The circuit of Fig. 3 described above can be constructed by connecting discrete parts. However, it is preferred to make it in the form of IC or to incorporate it into the IC having other circuits. The carrierwave oscillating circuit (9) which concurrently serves as the modulation circuit does not require any filter circuit including an inductance and, therefore, takes a shape convenient for it to be fabricated into an IC. When to be fabricated into the IC, an area encircled by the chain line in Fig. 3 can be constituted by an IC(17) (18) (19) and (20) located at the boundary thereof are terminal pins of the IC(17). To the terminal pin (18), an oscillating circuit (12) including the variable inductance coil $(L_1)$ and the capacitor $(C_1)$ is connected exteriorly. On the other hand, to the terminal pins (19) and (20) are connected exteriorly the reed filter (10) of the modulating signal oscillating circuit (8). It is to be noted that the reed filter (10) need not be the one peculiar to the oscillating circuit (8) and may be replaced with a quartz oscillator or a CR oscillating circuit.

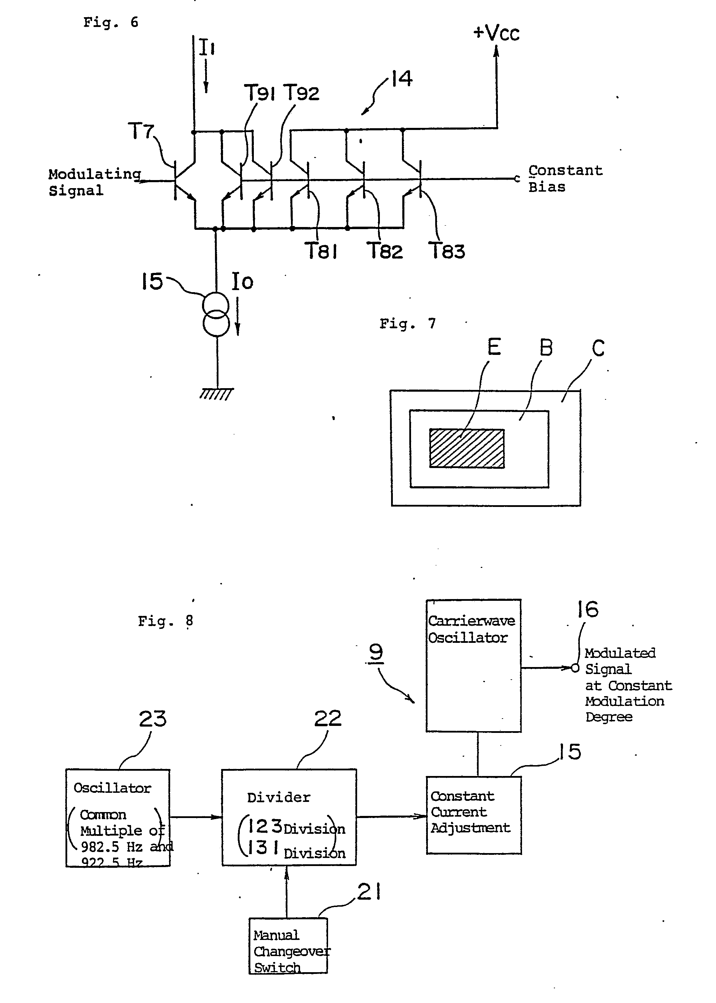

Fig. 6 illustrates another example of the constant current adjusting means (14). It comprises discrete transistors $(T_7)$, $(T_{91})$, $(T_{92})$, $(T_{81})$, $(T_{82})$ and $(T_{83})$ of uniform characteristic. The number of transistor $(T_7)$ to which the modulating signal is supplied is one, the number of transistors $(T_{91})$, $(T_{92})$ having their bases adapted to be applied with a constant bias and connected to the differential amplifier is two, and the number of transistors $(T_{81})$, $(T_{82})$, $(T_{83})$ connected to the common power source +Vcc is three. Needless to say, these transistors can be functionally classified into three types and the transistors in each of these types may be provided in a plural number.

In case of the circuit of Fig. 6, the AM degree is

$$\frac{3}{7} \times 100 \fallingdotseq 43 (\%)$$

conversely, where the modulation degree is desired to be 60%, this can be accomplished by eliminating the transistor $(T_{92})$ from the circuit shown in Fig. 6. For example:

$$m = \left( \frac{1 - \dfrac{1}{4}}{1 + \dfrac{1}{4}} \right) \times 100 = \frac{3}{5} \times 100 = 60 (\%)$$

Thus, when to design the modulation circuit with the modulation degree determined beforehand, to fabricate into an IC appears feasible. While a schematic plan view of one transistor is shown in Fig. 7, by changing the surface area of one of the collector, base and emitter layers C, B and E, for example, that of the emitter layer, the current flowing through the transistors of equal characteristic can be controlled. By way of example, when the circuit of Fig. 3 is fabricated into an IC and it is assumed that the surface area of the transistor $(T_7)$ is S7, and the respective surface areas of the transistors $(T_8)$ and $(T_9)$ are S8 and S9 and that S7:S8:S9=1:3:1, the modulation circuit having a modulation degree of 60% can be obtained. In general, when S7:S8:S9=1:n:l,

$$m = \frac{100n}{2l+n} (\%).$$

Where the modulation degree is determined beforehand the IC should be fabricated according to this general equation.

Fig. 8 illustrates a portion of the device for switching a multiplex sound signal included in a television signal recorded by, for example, a VTR. In a multiplex sound broadcasting system now embodied in Japan, a pilot signal of 982.5 Hz and that of 922.5 Hz are employed respectively for the stereophonic broadcasting and the duplex sound broadcasting. With the use of the carrier-wave of 55.125 KHz in frequency, these pilot signals are amplitude-modulated at a constant modulation degree and are then supplied to the antenna terminal of a television receiver set.

A manual changeovers switch (21) is a manipulatable switch for selecting one of the receipt of the stereophonic or duplex sound broadcasting and that of the monophonic sound broadcasting and feeds the selected signal to a divider circuit (22). An oscillating circuit (23) is a circuit for oscillating at a common multiple of the frequencies, 982.5 Hz and 922.5 Hz, of the pilot signals, that is, at 120.8475 KHz. In the divider circuit (22), either the division by 123 (stereophonic broadcasting) or the division by 132 (duplex sound broadcasting) is carried out depending on the voltage signal from the changeover switch (21) and it supplies either one of the pilot signals to the constant current adjusting means (15) as a modulating signal. As hereinbefore described, from the output terminal (16) comes the modulated signal modulated at the constant modulation degree, the pilot signal is then detected in the television receiver set and discriminated.

**Claims**

1. An amplitude modulation circuit comprising an oscillator (9) for producing a carrier-wave and a variable current supply means (14; 15) for varying the current supply to said oscillator responsive to a modulation signal for amplitude modulating said carrier-wave,

said oscillator (9) comprising two transistors ($T_{13}$, $T_{14}$) connected to form a differential amplifier (13), a positive feedback connection from the collector of one transistor ($T_{14}$) to the gate of the other transistor ($T_{13}$), and a resonating circuit (12) coupled to said feedback connection for determining the frequency of said carrierwave,

said variable current supply means (14, 15) being connected to a ground terminal of said differential amplifier (13),

characterized in that said variable current supply means comprises

current switching means (14) connected between a constant current source (15) and said differential amplifier (13) and having two switching states responsive to said modulating signal, said two switching states determining two different predetermined values ($I_0$, $I_1$) of constant current supplied to said oscillator.

2. An amplitude modulation circuit as defined in claim 1, wherein said current switching means (14) comprises a plurality of first transistors ($T_7$, $T_9$) having their collectors connected to said oscillator (9), and at least one second transistor ($T_8$) having its collector connected to a power line (+Vcc), the emitters of said first and second transistors being connected to said constant current source (15), the gate of one ($T_7$) of said first transistors being supplied with said modulating signal and the gates of the other transistors ($T_8$, $T_9$) being supplied with a constant bias.

3. An amplitude modulation circuit as defined in claim 2, wherein said plurality of first transistors ($T_7$, $T_9$) comprises two transistors connected to form a differential pair.

4. An amplitude modulation circuit as defined in claim 2 or 3, wherein the surface areas of the emitters of said first transistors ($T_7$, $T_9$) and said at least one second transistor ($T_8$) are selected to be in a predetermined ratio.

**Patentansprüche**

1. Schaltkreis zur Amplitudenmodulation mit einem Oszillator (9) zum Erzeugen einer Trägerwelle und mit einer variablen Stromversorgungsvorrichtung (14, 15) zum Variieren der Stromzufuhr zum Oszillator in Abhängigkeit von einem Modulationssignal zum Amplitudenmodulieren der Trägerwelle,

wobei der Oszillator (9) zwei Transistoren ($T_{13}$, $T_{14}$) aufweist, die so miteinander verbunden sind, daß sie einen Differentialverstärker (13) bilden, eine Mitkopplungsverbindung vom Kollektor eines Transistors ($T_{14}$) zum Gate des anderen Transistors ($T_{13}$) und einen Resonanzschaltkreis (12), der mit der Mitkopplungsverbindung gekoppelt ist, um die Frequenz der Trägerwelle zu bestimmen, wobei die variable Stromversorgungsvorrichtung (14, 15) mit dem Masseanschluß des Differentialverstärkers (13) verbunden ist,

dadurch gekennzeichnet, daß die variable Stromversorgungsvorrichtung aufweist

eine Stromschaltvorrichtung (14), die zwischen einer Konstantstromquelle (15) und dem Differentialverstärker (13) geschaltet ist und zwei Schaltzustände hat, in Abhängigkeit vom Modulationssignal, wobei die zwei Schaltzustände zwei unterschiedliche vorbestimmte Werte ($I_0$, $I_1$) des zum Oszillator zugeführten Konstantstroms bestimmen.

2. Schaltkreis nach Anspruch 1, dadurch gekennzeichnet, daß die Stromschaltvorrichtung (14) eine Vielzahl von ersten Transistoren ($T_7$, $T_9$) aufweist deren Kollektoren mit dem Oszillator (9) verbunden sind, und mindestens einen zweiten Transistor ($T_8$), dessen Kollektor mit einer Spannungsleitung (+$V_{cc}$) verbunden ist, wobei die Emitter der ersten und zweiten Transistoren mit der Konstantstromquelle (15) verbunden sind, das Gate eines ($T_7$) der ersten Transistoren mit dem Modulationssignal beaufschlagt wird und die Gates der anderen Transistoren ($T_8$, $T_9$) mit einer konstanten Vorspannung beaufschlagt werden.

3. Schaltkreis nach Anspruch 2, dadurch gekennzeichnet, daß die Vielzahl von ersten Transistoren ($T_7$, $T_9$) zwei Transistoren aufweist, die ein Differentialpaar bilden.

4. Schaltkreis nach einem der Ansprüche 2 oder 3 dadurch gekennzeichnet, daß die Oberflächenbereiche der Emitter der ersten Transistoren ($T_7$, $T_9$) und des mindestens einen zweiten Transistors ($T_8$) so gewählt sind, daß sie ein vorbestimmtes Verhältnis bilden.

**Revendications**

1. Circuit de modulation d'amplitude comprenant un oscillateur (9) pour produire une onde porteuse et un moyen d'alimentation en courant variable (14, 15) pour faire varier l'alimentation en courant vers l'oscillateur en réponse à un signal de modulation pour moduler en amplitude l'onde porteuse,

l'oscillateur (9) comprenant deux transistors ($T_{13}$, $T_{14}$) connectés pour former un amplificateur différentiel (13), une connexion de réaction positive en provenance du collecteur d'un transistor ($T_{14}$) vers la grille de l'autre transistor ($T_{13}$), et un circuit résonnant (12) couplé à la connexion de réaction pour déterminer la fréquence de l'onde porteuse,

ledit moyen d'alimentation en courant variable (14, 15) étant connecté à une borne de masse de l'amplificateur différentiel (13),

caractérisé en ce que le moyen d'alimentation en courant variable comprend:

un moyen de commutation de courant (14) connecté entre une source de courant constant (15) et l'amplificateur différentiel (13) et ayant deux états de commutation sensibles au signal de modulation, ces deux états de commutation déterminant deux valeurs prédéterminées ($I_0$, $I_1$) du courant constant fourni à l'oscillateur.

2. Circuit de modulation d'amplitude selon la revendication 1, dans lequel le moyen de commutation de courant (14) comprend une pluralité de premiers transistors ($T_7$, $T_9$) ayant leurs collecteurs connectés à l'oscillateur (9) et au moins un second transistor ($T_8$) ayant son collecteur connecté à une ligne d'alimentation (+Vcc), les émetteurs des premier et second transistors étant connectés à ladite source de courant constant (15), la borne de commande de l'un ($T_7$) desdits premiers transistors étant alimentée par le signal de modulation et les bornes de commande des autres transistors ($T_8$, $T_9$) étant alimentées par une polarisation constante.

3. Circuit de modulation d'amplitude selon la revendication 2, dans lequel ladite pluralité de premiers transistors ($T_7$, $T_9$) comprend deux transistors connectés pour former une paire différentielle.

4. Circuit de modulation d'amplitude selon l'une des revendications 2 ou 3, dans lequel les surfaces des émetteurs des premiers transistors ($T_7$, $T_9$) et d'au moins un second transistor ($T_8$) sont choisies pour être dans un rapport prédéterminé.

Fig. 1

Fig. 2

(a)                                                    fo

(b)                                                    Fo

(c)                                                    Fo

A    B

Fig. 3

Fig. 5

Fig. 4

(a)

(b) Transistor T7

(c) Transistor T8,T9

(d)

2

Fig. 6

Fig. 7

Fig. 8